# EUROPEAN PATENT SPECIFICATION

(11) **EP 1 530 242 B1**
(45) Date of publication and mention of the grant of the patent: **02.05.2012**
(21) Application number: 04025811.3
(22) Date of filing: 29.10.2004
(51) Int. Cl.: H01L 33/38, H01L 33/40

(54) **Semiconductor light emitting device**
Lichtemittierendes Halbleiterbauelement
Dispositif émetteur de lumière à semi-conducteur

(30) Priority: 06.11.2003 JP 2003377204
(43) Date of publication of application: 11.05.2005
(73) Proprietor: Sumitomo Electric Industries, Ltd., Osaka-shi, Osaka 541-0041 (JP)
(72) Inventor: Ikeda, Ayako, 1-1, Koyakita 1-chome Itami-shi Hyogo (JP); Nagai, Youichi, 1-1, Koyakita 1-chome Itami-shi Hyogo (JP); Nakamura, Takao, 1-1, Koyakita 1-chome Itami-shi Hyogo (JP)
(74) Representative: Grünecker, Kinkeldey, Stockmair & Schwanhäusser

(56) References cited:
- DE-U1- 20 202 493
- JP-A- 6 310 757
- JP-A- 2002 151 739
- JP-A- 2002 217 450
- US-A- 5 917 202
- US-A1- 2002 000 558
- US-A1- 2003 111 667
- US-B1- 6 222 207

## Description

### BACKGROUND OF THE INVENTION

### Field of the Invention

The present invention relates to a semiconductor light emitting device using nitridebased semiconductors.

### Related Background of the Invention

Recently, short-wavelength light emitting diodes (LEDs), such as blue LEDs and ultraviolet LEDs, have vigorously been developed and are put to practical use. These LEDs are made of GaN-based compound semiconductors with wide bandgaps. For example, Patent Document 1 (Japanese Patent Application Laid-Open No. 11-191641) discloses a semiconductor light emitting device. In semiconductor light emitting device, a GaN epitaxial buffer layer is provided on a sapphire substrate. On the GaN buffer layer, an n-type GaN layer, an InGaN active layer, a p-type AlGaN layer, and a p-type GaN layer are successively stacked. This semiconductor light emitting device is mounted face down (flip chipped) on a wiring substrate so as to turn the sapphire substrate upward. Light traveling from the InGaN active layer is output through the sapphire substrate.

In order to increase the output efficiency of light, the semiconductor light emitting device in Patent Document 1 has a stack structure containing an ohmic layer for p-type ohmic contact and a reflecting layer for reflecting light from the InGaN active layer. The reflecting layer reflects the light to form reflected light for the sapphire substrate.

### SUMMARY OF THE INVENTION

In the semiconductor light emitting device described above, the ohmic layer is provided between the InGaN active layer and the reflecting layer. Generally, the ohmic layer is made of metal, such as Ni, Co, or Sb, making a good ohmic contact with GaN. As described in Patent Document 1, these metals however have not so high reflectance of light and have low transmittance of light. Thus, reflected light from the reflecting layer is attenuated by the ohmic layer, so that the output efficiency of light is decreased. In order to solve this problem, the semiconductor light emitting device of Patent Document 1 includes an ohmic layer as thin as possible, but the problem is not completely solved thereby.
Document US 2003/0111667 A1 relates to a light emitting diode comprising a top contact defining an area underlying the top contact, a conductive holder, a light emitting region dispersed between the top contact and the conductive holder, and an omni-directional reflector disposed between the light emitting region and the conductive holder, the omni-directional reflector having one or more electrically conductive contacts configured to correspond to a region beyond the area underlying the top contact.

Document US 6,222,207 B1 relates to a light emitting structure comprising a light emitting diode, a reflecting layer coupled to the diode, a solder layer on a side of the reflecting layer opposite the diode and a diffusion barrier positioned between and in contact with both said reflecting layer and said solder layer for isolating the layers from each other, wherein said diffusion barrier consists of a single layer of uniform material composition.

It is an object of the present invention to provide a semiconductor light emitting device which can increase the output efficiency of light generated by the active layer.

In order to achieve the above object, a semiconductor light emitting device according to the present invention comprises: a first conductivity type semiconductor layer made of nitride semiconductor; a second conductivity type semiconductor layer made of nitride semiconductor, the second conductivity type semiconductor layer being provided on the first conductivity type semiconductor layer; an active layer made of nitride semiconductor, the active layer being provided between the first conductivity type semiconductor layer and the second conductivity type semiconductor layer; a first electrode electrically connected to the first conductivity type semiconductor layer; a second electrode provided on the second conductivity type semiconductor layer, the second electrode having a predetermined pattern; and a reflecting metal layer provided on the second conductivity type semiconductor layer and the second electrode, wherein a surface of the second conductivity type semiconductor layer has a first region and a second region surrounding the first region, and the second electrode is provided on the first region. In the semiconductor light emitting device according to the present invention, a surface of the second conductivity type semiconductor layer has a first region and a second region surrounding the first region. The patterned second electrode includes a first portion having a first pattern on the first region and a second portion having a second pattern on the second region. A ratio of a planar dimension of the first portion of the patterned second electrode to that of the first region is larger than a ratio of a planar dimension of the second portion of the patterned second electrode to that of the second region.

The second electrode is patterned in this semiconductor light emitting device, and the reflecting metal layer is provided both on the patterned second electrode and the second conductivity type semiconductor layer. In this structure, light traveling from the active layer is reflected to the substrate by the reflecting metal layer provided on the second conductivity type semiconductor layer, and is emitted through the substrate to the outside of the semiconductor light emitting device. Thus, the reflected light is not attenuated by the ohmic layer or the like, so that the output efficiency of light generated by the active layer can be increased.

In the semiconductor light emitting device according to the present invention, the first conductivity type semiconductor layer is made of Al_{X1}Ga_{1-X1}N (0 ≤ X1 < 1) and the second conductivity type semiconductor layer is made of Al_{X2}Ga_{1-X2}N (0 ≤ X2 < 1), and the active layer is made of Al_{X3}In_{Y3}Ga_{1-X3-Y3}N (0 ≤ X3 < 1, 0 ≤ Y3 < 1, 0 ≤ X3+Y3 < 1). This semiconductor light emitting device can efficiently generate light of a relatively short wavelength such as blue light or ultraviolet light.

The semiconductor light emitting device according to the present invention further comprises a substrate made a GaN-based compound. The first conductivity type semiconductor layer is provided on a primary surface of the substrate, and the first electrode being provided on a back surface of the substrate. The semiconductor light emitting device does not places any restrictions on the dimensions of the semiconductor layers because the first electrode and the second electrode can be placed on one side and the opposite side of the semiconductor light emitting device, respectively, thereby increasing the luminous efficiency in the active layer.

In the semiconductor light emitting device according to the present invention, a specific resistance of the substrate is not more than 0.5 Ωcm. This substrate achieves good electrical conductivity of the substrate and facilitates the spreading of electric current in the substrate. Thus, the current density in the active layer becomes almost uniform, so that the luminous efficiency in the active layer can be further increased.

In the semiconductor light emitting device according to the present invention, reflectance of metal of the reflecting metal layer is not less than 80 percent in a wavelength range of not less than 400 nanometers nor more than 800 nanometers. The semiconductor light emitting device can further increase the optical output efficiency if the active layer generates light containing wavelength components of visible light.

In the semiconductor light emitting device according to the present invention, the reflecting metal layer is made of metal containing at least one of silver (Ag) and aluminum (Al). If the reflecting metal layer is made of one of these metals providing a high optical reflection, the output efficiency of light generated by the active layer can be further increased.

In general, light generated by the active layer tends to be in the marginal region of the semiconductor light emitting device. In both of the above the semiconductor light emitting devices, the planar dimension of the reflecting metal layer in the marginal region (i.e., the second region) becomes larger, whereby the output efficiency of light generated by the active layer can be further increased.

In the semiconductor light emitting device according to the present invention, the pattern is a lattice shape. In the semiconductor light emitting device according to the present invention, the lattice shape of the pattern is constituted by a unit lattice for forming the pattern and a side of the unit lattice is not more than 60 micrometers. More preferably, each side of the unit lattice is not more than 60 micrometers. Since this semiconductor light emitting device can supply a sufficient driving current to the active layer, the reduction of the luminous efficiency due to the patterned structure of the second electrode can be suppressed.

In the semiconductor light emitting device according to the present invention, preferably, the pattern is constituted by a plurality of units separated from each other. More preferably, the plurality of units are regularly arranged to form the pattern and each unit in the pattern has four or six nearest neighbor units. More preferably, the interval between the units adjacent to each other is not more than 60 micrometers. In these semiconductor light emitting devices, a sufficient driving current can be uniformly supplied to the active layer, and it is thus feasible to suppress the decrease of the luminous efficiency due to the patterned structure of the second electrode.

In the semiconductor light emitting device according to the present invention, the interval between the edge of the second electrode and any point on the second conductivity type semiconductor layer outside the second electrode is not more than 30 micrometers. Since this semiconductor light emitting device can uniformly supply a sufficient driving current to the active layer, it can suppress the deterioration of the luminous efficiency due to the patterned structure of the second electrode.

In the semiconductor light emitting device according to the present invention, the contact resistivity between the second electrode and the second conductivity type semiconductor layer is not more than 1 × 10⁻³ Ωcm². Since this semiconductor light emitting device can reduce heat generated in the contact between the second electrode and the second conductivity type semiconductor layer, it can prevent reduction of the luminous efficiency and increase of power consumption due to the heat.

In the semiconductor light emitting device according to the present invention, the second electrode is made of at least one metal of Ni, Au, Pt and Pd. This semiconductor light emitting device has the excellent ohmic contact between the second electrode and the second conductivity type semiconductor layer.

The semiconductor light emitting device according to the present invention, further comprises a contact layer provided on the second conductivity type semiconductor layer. The contact layer is contacted with the second electrode. This semiconductor light emitting device has the excellent ohmic contact between the second electrode and the second conductivity type semiconductor layer.

In the semiconductor light emitting device according to the present invention, a planar dimension of the second electrode is not less than 10 percent of that of the second conductivity type semiconductor layer. When the planar dimension of the second electrode is smaller than 10 percent of that of the second conductivity type semiconductor layer, the contact resistance increases between the second electrode and the second conductivity type semiconductor layer, thereby increasing the power consumption and decreasing the luminous efficiency in the active layer because of the generated heat. In contrast, the semiconductor light emitting device of the present invention has a low contact resistance in the contact between the second electrode and the second conductivity type semiconductor layer, and thus can prevent the deterioration of the luminous efficiency and the increase of power consumption due to the heat.

The semiconductor light emitting device according to the present invention comprises an adhesive layer containing titanium (Ti), the adhesive layer being provided between the reflecting metal layer and the second conductivity type semiconductor layer and between the reflecting metal layer and the second electrode. This semiconductor light emitting device can prevent the reflecting metal layer from peeling off from the second conductivity type semiconductor layer and from the second electrode without the deterioration of the electrical connection between the second electrode and the reflecting metal layer.

### BRIEF DESCRIPTION OF THE DRAWINGS

The above-described object and other objects, features, and advantages of the present invention will become apparent more easily in the detailed description of the preferred embodiments of the present invention which will be described below with reference to the accompanying drawings:
Fig. 1 is a cross sectional view showing a light emitting diode according to the first comparative example of the semiconductor light emitting device;
Fig. 2 is a cross sectional view showing an active layer in the light emitting diode of the first comparative example;
Fig. 3 comparative example is a plan view showing an anode electrode and a reflecting metal layer of the light emitting diode of the first comparative example;
Fig. 4 is an enlarged cross sectional view of the vicinity of an anode electrode and a reflecting metal layer;
Fig. 5 is a graph showing a relationship between driving current and emission intensity both in a conventional semiconductor light emitting device having an anode electrode and a cathode electrode on the same side thereof and in a light emitting diode having an anode electrode on one side thereof and a cathode electrode on the other side.
Fig. 6 is a graph showing a relationship between coverage of an anode electrode with a p-type contact layer thereon, and the reflection rate of light from the active layer on a reflecting metal layer;
Fig. 7 is a graph showing a relationship between driving current and emission intensity where the coverage of a p-type contact layer with an anode electrode is 5 percent, 10 percent, and 100 percent;
Fig. 8 is a graph showing a relationship between the coverage and driving voltage where the driving current is 100 mA and 20 mA;
Fig. 9A is a view showing electrodes for anode arranged on the contact layer, and Fig. 9B is an illustration showing a current density in an active layer dependent on distance from the anode electrode;
Fig. 10 is an illustration showing a light emitting diode according to the second comparative example of the semiconductor light emitting device;
Fig. 11 is a view of a p-type contact layer in a light emitting diode of the first embodiment;
Fig. 12 is an illustration showing a light emitting diode according to the second comparative example of the semiconductor light emitting device; and
Fig. 13 is an illustration showing a light emitting diode according to the second embodiment of the semiconductor light emitting device of the present invention.

### DESCRIPTION OF THE PREFERRED EMBODIMENTS

The teaching of the present invention can be easily understood by considering the following detailed description taken in conjunction with the accompanying drawings shown as examples. The use of the same reference symbols in different drawings indicates similar or identical items, if possible.

### (First Comparative example)

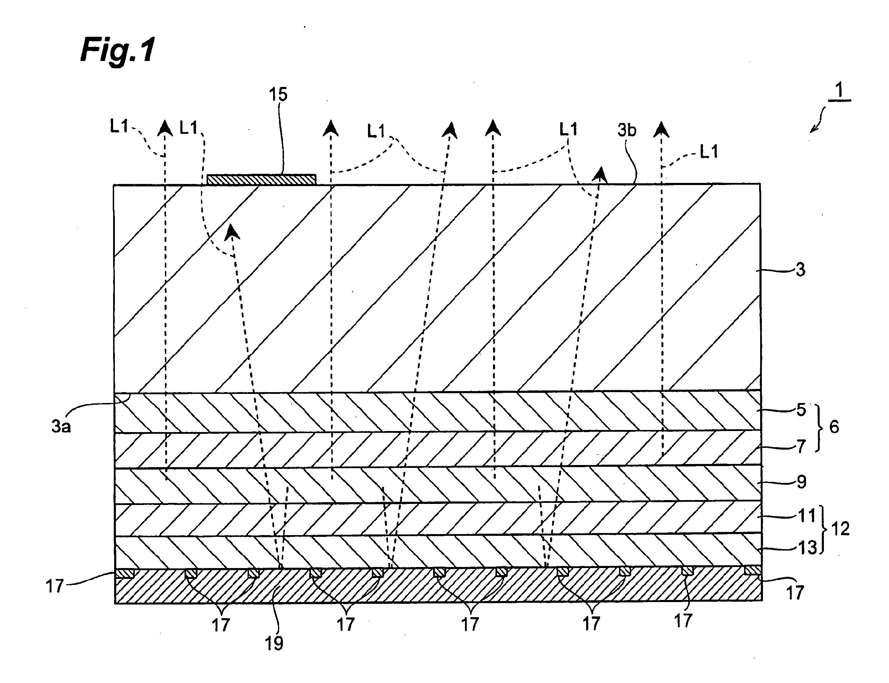

Fig. 1 is a cross sectional view of a light emitting diode 1 shown as the first comparative example of the semiconductor light emitting device. The light emitting diode 1 has dimensions of approximately 400 micrometers x 400 micrometers in planar shape and the thickness of approximately 200 micrometers, for example. The light emitting diode 1 of the present embodiment emits blue light of the wavelength 450 nanometers, for example.

With reference to Fig. 1, the light emitting diode 1 has a substrate 3. The light emitting diode 1 has an n-type (first conductivity type) semiconductor layer 6, a p-type (second conductivity type) semiconductor layer 12, and an active layer 9. The n-type semiconductor layer 6 includes an n-type buffer layer 5 and an n-type cladding layer 7. The p-type semiconductor layer 12 includes a p-type cladding layer 11 and a p-type contact layer 13. The n-type buffer layer 5, n-type cladding layer 7, active layer 9, p-type cladding layer 11, and p-type contact layer 13 are epitaxially grown in order on a primary surface 3a of the substrate 3 by MOVPE. Further, the light emitting diode 1 has a cathode electrode 15, an anode electrode 17 and a reflecting metal layer 19.

The substrate 3 is made of a conductive GaN-based compound. In the present comparative example, the substrate 3 is made of GaN. The substrate 3 can transmit light generated by the active layer 9. The specific resistance of the substrate 3 is not more than 0.5 Ωcm. The n-type buffer layer 5 is formed on the primary surface 3a of the substrate 3. The n-type buffer layer 5 is made of a nitride semiconductor doped with an n-type dopant. In the present embodiment, the n-type buffer layer 5 is made of GaN doped with silicon (Si), for example.

The n-type cladding layer 7 is made of a nitride semiconductor doped with an n-type dopant. In the present comparative example, for example, the n-type cladding layer 7 is made of Al_{X1}Ga_{1-X1}N (0 ≤ X1 < 1) doped with Si. The n-type cladding layer 7 is formed on the n-type buffer layer 5.

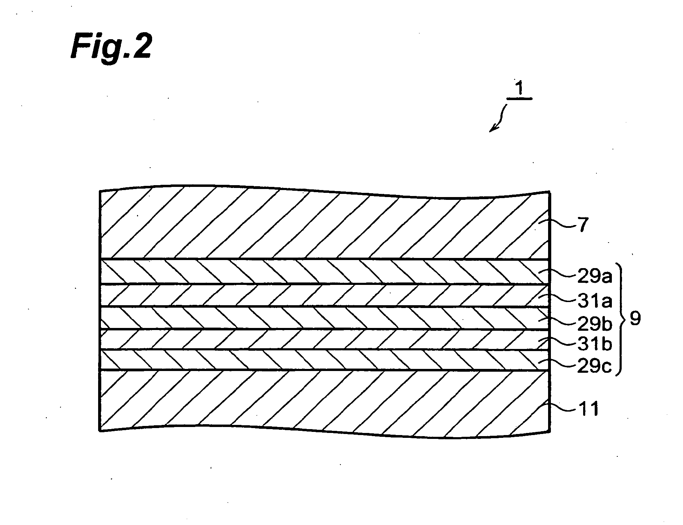

The active layer 9 is provided on the n-type cladding layer 7 and has a multiple quantum well structure. Fig. 2 is a cross sectional view showing the structure of the active layer 9 in the present comparative example. With reference to Fig. 2, the active layer 9 includes barrier layers 29a to 29c and well layers 31a and 31b, and the active layer 9 is constituted by the barrier layer 29a, well layer 31a, barrier layer 29b, well layer 31b, and barrier layer 29c that are arranged sequentially on the n-type cladding layer 7.

Each of the barrier layers 29a to 29c and the well layers 31a and 31b is made of a GaN-based semiconductor such as Al_{X2}In_{Y2}Ga_{1-X2-Y2}N (0 ≤ X2 < 1, 0 ≤ Y2 < 1, 0 ≤ X2+Y2 < 1). In the present comparative example, the composition of the barrier layers 29a to 29c is 0 < X2 < 1 and Y2 = 0, and the composition of the well layers 31a and 31b is 0 < X2 < 1 and 0 < Y2 < 1. The compositions of the barrier layers 29a to 29c and the well layers 31a and 31b are adjusted such that the bandgap of the barrier layers 29a to 29c is larger than that of the well layers 31a and 31b.

The p-type cladding layer 11 is made of a nitride semiconductor doped with a p-type dopant. In the present comparative example, for example, the p-type cladding layer 11 is made of Al_{X1}Ga_{1-X1}N (0 ≤ X1 < 1) doped with magnesium (Mg). The p-type cladding layer 11 is formed on the active layer 9, and the active layer 9 is thus located between the n-type cladding layer 7 and the p-type cladding layer 11.

The p-type contact layer 13 establishes a good electric connection between the p-type cladding layer 11 and the anode electrode 17, and is made of a nitride semiconductor doped with a p-type dopant. In the present comparative example, for example, the p-type contact layer 13 is made of GaN doped with Mg. The p-type contact layer 13 is formed on the p-type cladding layer 11.

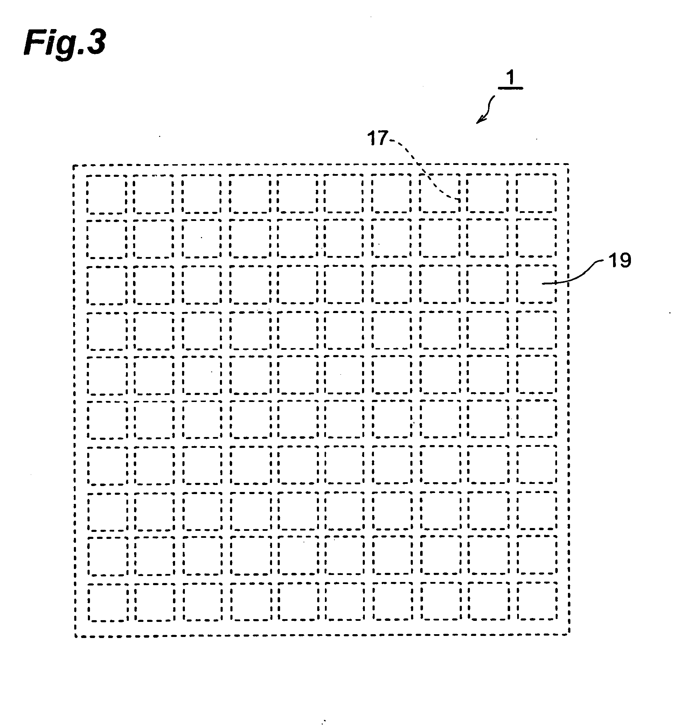

The anode electrode 17 is provided on the p-type contact layer 13. In the present comparative example, the anode electrode 17 is used as the second electrode. The thickness of the anode electrode 17 is, for example, not more than 5 nanometers. Fig. 3 is a view showing a patterned anode electrode on one side of the light emitting diode 1. As shown in Fig. 3, the anode electrode 17 has a uniform pattern formed on the p-type contact layer 13. The "uniform pattern" is formed by arranging a number of basic cells, each having a certain shape, on a regular and periodic basis. The anode electrode 17 has a pattern such as a lattice pattern. The pattern of the anode electrode 17 is preferably formed so that the coverage of the contact layer 13 with the anode electrode 17 is not less than 10 percent nor more than 60 percent in the light emitting diode 1. In the present comparative example, the pattern of the anode electrode 17 is formed such that the area of the anode electrode 17 is 23 percent of the surface of the p-type contact layer 13 with.

In the present comparative example, one side of a unit lattice in the lattice pattern of the anode electrode 17 is not more than 60 micrometers. In other words, the distance from the anode electrode 17 to any point on the p-type contact layer 13 not covered with the anode electrode 17 is not more than 30 micrometers in the present comparative example. The width of the lattice frame in the anode electrode 17 is, for example, not more than 100 micrometers.

In the present comparative example, the contact resistivity between the anode electrode 17 and the p-type contact layer 13 is not more than 1 × 10⁻³ Ωcm². In order to form the ohmic contact between the anode electrode 17 and the p-type contact layer 13, the anode electrode 17 and the p-type contact layer 13 contacted therewith are heated in the production process of the light emitting diode 1. This makes it feasible to make a contact resistivity low.

In order to suitably form the ohmic contact between the anode electrode 17 and the p-type contact layer 13, the anode electrode 17 is preferably made of at least one metal selected from Ni, Au, Pt, and Pd. In the present comparative example, the anode electrode 17 has a stack structure constituted by depositing a nickel (Ni) layer and a gold (Au) layer.

The reflecting metal layer 19 is a film for reflecting light L1 generated by the active layer 9, and the reflected part of light L1 travels from the active layer 9 in a direction opposite to the substrate 3. The reflecting metal layer 19 is made of metal to apply a driving current from outside to the anode electrode 17 of the light emitting diode 1. The reflecting metal layer 19 is formed on both the p-type contact layer 13 and the anode electrode 17. Namely, the reflecting metal layer 19 covers both the anode electrode 17 and the p-type contact layer 13 on which the lattice pattern of the anode electrode 17 is not located (i.e., apertures of the lattice). The reflecting metal layer 19 is made of metal having a higher reflectance at the wavelength of the light L1 than the anode electrode 17. For example, the reflecting metal layer 19 is preferably made of metal containing at least one of Ag and Al which have high reflectance in a wavelength range of visible light, i.e., a wavelength region of 400 nanometers to 800 nanometers. Preferably, the reflecting metal layer 19 is made of metal having reflectance of not less than 80 percent in the above wavelength region of visible light.

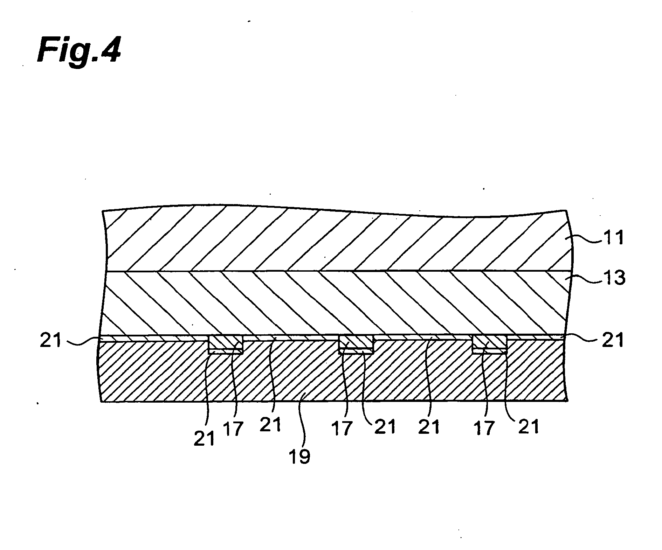

Fig. 4 is an enlarged cross sectional view of the vicinity of the anode electrode 17 and the reflecting metal layer 19. With reference to Fig. 4, the light emitting diode 1 has an adhesive layer 21 of titanium (Ti) between the reflecting metal layer 19 and the anode electrode 17 and between the reflecting metal layer 19 and the p-type contact layer 13. The adhesive layer 21 is provided to enhance bonding strength of the reflecting metal layer 19 to the anode electrode 17 and to the p-type contact layer 13. The thickness of the adhesive layer 21 is, for example, not more than 2 nanometers.

Again referring to Fig. 1, the cathode electrode 15 is provided on a part of the back surface 3b of the substrate 3. The cathode electrode 15 is used as the first electrode in the present comparative example. The cathode electrode 15 is electrically connected, for example, through a bonding wire to an electrode pad (not shown), and a driving voltage is applied between the cathode electrode 15 and the reflecting metal layer 19 from outside.

The above-described light emitting diode 1 operates in a manner as below. When the driving current is applied between the reflecting metal layer 19 and the cathode electrode 15 from outside, an electric field is generated between the anode electrode 17 and the cathode electrode 15. Carriers are injected from the n-type semiconductor layer 6 and the p-type semiconductor layer 12 into the active layer 9 to generate light L1 in the active layer 9. The light L1 generated by the active layer 9 goes in all directions, and a part of the light L1 which travels to the anode side is reflected by the reflecting metal layer 19, and the reflected light is emitted through the substrate 3 to the outside of the light emitting diode 1.

The anode electrode 17 is formed by the method as described below. First, a nickel (Ni) layer is formed on the p-type contact layer 13 by evaporation or sputtering. Then, the Ni layer is patterned into a lattice shape by lift-off technique or etching. Subsequently, a thermal treatment is carried out at the temperature of not less than 400 degrees Celsius to form the ohmic contact between the Ni layer and the p-type contact layer 13. Next, a gold (Au) layer is formed on the Ni layer by evaporation or sputtering. In this manner, the anode electrode 17 of Ni/Au is formed in the lattice pattern.

The light emitting diode 1 described above has the following advantage. Since the anode electrode 17 is patterned into the lattice shape and the reflecting metal layer 19 is provided both on the anode electrode 17 and the p-type contact layer 13 in the apertures of the lattice, the light L1 traveling from the active layer 9 in a direction opposite to the substrate 3 is suitably reflected by the reflecting metal layer 19 provided on the p-type contact layer 13, passes through the substrate 3, and is emitted to the outside of the light emitting diode 1. The light emitting diode 1 of the present comparative example, therefore, does not attenuate the light L1 due to the reflection by the reflecting metal layer 19, unlike the ohmic layer or the like in Patent Document 1, and it is thus feasible to increase the optical output efficiency of light L1 generated by the active layer 9.

In the light emitting diode 1 of the present comparative example, the n-type semiconductor layer 6 and the p-type semiconductor layer 12 include the n-type cladding layer 7 and the p-type cladding layer 11 of Al_{X1}Ga_{1-X1}N, respectively. The active layer 9 includes the barrier layers 29a to 29c and well layers 31a and 31b, each of which is made of at least one semiconductor material selected from GaN, Al_{X2}Ga_{1-X2}N, In_{Y2}Ga_{1-Y2}N, and Al_{X3}In_{Y3}Ga_{1-X3-Y3}N . This makes it feasible to efficiently generate light of a relatively short wavelength such as blue light or ultraviolet light.

In the conventional semiconductor light emitting device as disclosed in Patent Document 1 (particularly, that uses a sapphire substrate), the substrate is not electrically conductive and thus the anode electrode and the cathode electrode are placed on one side of the semiconductor light emitting device. In contrast thereto, the light emitting diode 1 of the present comparative example has the cathode electrode 15 provided on the back side 3b of the substrate 3 made of a conductive GaN-based compound, the cathode electrode 15 is located on one side of the light emitting diode 1 and the anode electrode 17 is located the other side thereof.

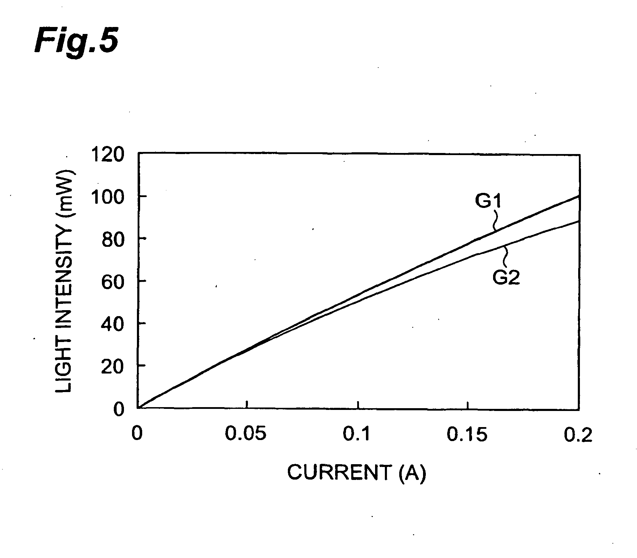

Fig. 5 is a graph showing the relationship between driving current and emission intensity both in a conventional semiconductor light emitting device having the anode electrode and the cathode electrode on one side thereof and in the light emitting diode 1 having the anode electrode 17 and the cathode electrode 15 on one side and the opposite side thereof, respectively. In Fig. 5, line G1 represents the characteristics of the light emitting diode 1 and line G2 represents the characteristics of the conventional semiconductor light emitting device. As shown in Fig. 5, line G1 shows steady increase of the emission intensity with increase of the driving current, whereas line G2 shows decrease of the increasing rate of the emission intensity with increase of the driving current. It is thought that the reason for the above is that the luminous efficiency in the conventional semiconductor light emitting device is made low because of additional generation of heat and so on resulting from the reduction of the size of the p-type semiconductor layer (or the n-type semiconductor layer) caused by the arrangement of the abode and cathode electrodes on the same side. In contrast, the cathode electrode 15 and the anode electrode 17 are placed on one side and the opposite side of the light emitting diode, respectively, and thus there are no restrictions on the size of the semiconductor layers, such as the p-type cladding layer 11 and the active layer 9, due to the arrangement of the abode and cathode electrodes, thereby enhancing the luminous efficiency in the active layer 9.

In the light emitting diode 1 of the present comparative example, the specific resistance of the substrate 3 is not more than 0.5 Ωcm. If the substrate 3 preferably has this value of the specific resistance, such a low electrical resistance of the substrate 3 is sufficient to spread electric current in the substrate 3. Accordingly, the density of current to the active layer 9 becomes almost uniform and it is thus feasible to further increase the luminous efficiency in the active layer 9.

In the light emitting diode 1 of the present comparative example, the reflectance of metal of the reflecting metal layer 19 is preferably not less than 80 percent for the visible light in the wavelength range of not less than 400 nanometers nor more than 800 nanometers (400 nm ≤ wavelength ≤ 800 nm). This makes it feasible to further increase the optical output efficiency if the light L1 generated by the active layer 9 is in a visible light range.

In the light emitting diode 1 of the present comparative example, the reflecting metal layer 19 is made of metal containing at least one metal of Ag and Al. When the reflecting metal layer 19 is made of one of these metals providing a high reflection of light, the optical output efficiency of the light L1 from the active layer 9 can be further increased.

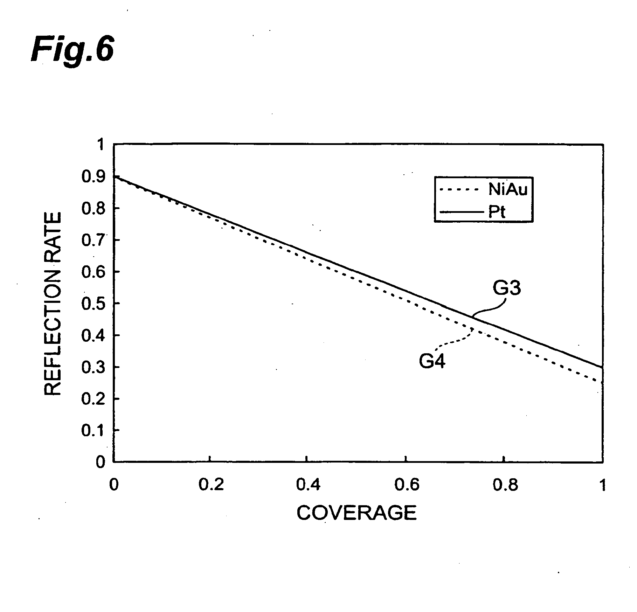

In the light emitting diode 1 according to the present comparative example, the planar dimension of the anode electrode 17 is preferably not more than 60 percent of that of the p-type contact layer 13. Fig. 6 is a graph showing the relationship between the coverage of the surface of the p-type contact layer 13 with the anode electrode 17 and the ratio (L_{R}/ L1) of light L_{R} reflected by the reflecting metal layer 19 to the light L1 traveling from the active layer in a direction opposite to the substrate 3. In Fig. 6, line G3 shows characteristics in a light emitting diode having an anode electrode made of Ni/Au, and line G4 shows characteristics in a light emitting diode having an anode electrode made of platinum (Pt). As shown in Fig. 6, if the coverage is not more than 60 percent, the reflection rate is not less than 50 percent in the both lines G3 and G4 because the planar dimensions of the anode electrode 17 is relatively small and consequently the planar dimensions of the reflecting metal layer 19 on the p-type contact layer 13 without the anode electrode is relatively large. According to Inventors' knowledge, the reflection rate of the conventional semiconductor light emitting device is less than 50 percent even with increase in the reflectance of the anode electrode itself. In contrast, since the reflection rate in the light emitting diode 1 according to the present comparative example is not less than 50 percent, the reflecting metal layer 19 can reflect more of light L1 from the active layer 9, thereby further increasing the output efficiency of light L1.

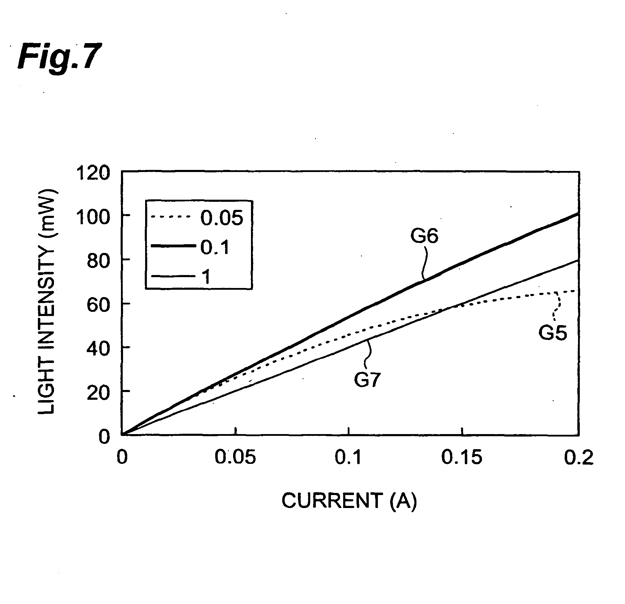

The area of the anode electrode 17 is preferably not less than 10 percent of the whole surface of the p-type contact layer 13. Fig. 7 is a graph showing the relationship between driving current and emission intensity where the coverage of the p-type contact layer 13 with the anode electrode 17 is 5 percent, 10 percent and 100 percent. In Fig. 7, lines G5, G6 and G7 represent the characteristics of the coverage 5 percent, 10 percent and 100 percent, respectively. As shown in Fig. 7, at the coverage of not less than 10 percent, the emission intensity suitably increases with increase of the driving current, but at the coverage of 5 percent the increase rate of the emission intensity becomes smaller relative to the increase rate of the driving current. It is thought that the reason for the above is that such a low coverage increases the contact resistance between the anode electrode 17 and the p-type contact layer 13 and excess heat generated thereby decreases the luminous efficiency in the active layer 9.

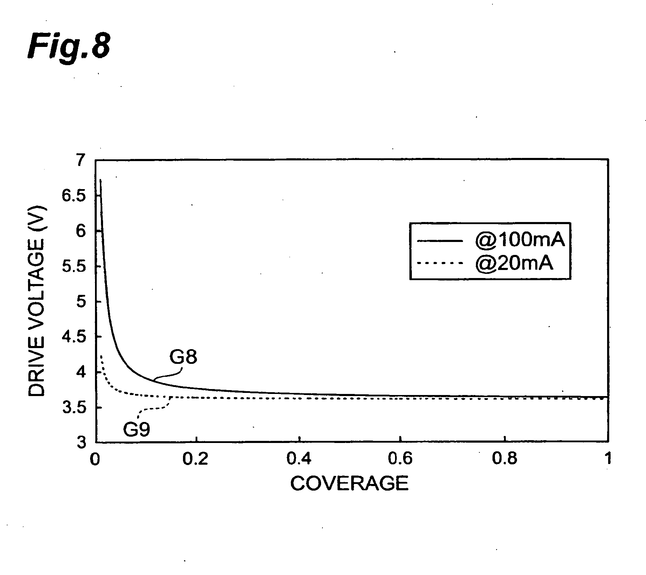

Fig. 8 is a graph showing the relationship between the coverage and driving voltage where the driving current is 100 mA and 20 mA. In Fig. 8, lines G8 and G9 show the characteristics of the driving current, 100 mA, and 20 mA, respectively. As shown in Fig. 8, lines G8 and G9 both show quick increase of the driving voltage in the range of the coverage of not more than 10 percent because this small coverage increases the density of current flowing through the anode electrode 17 and the p-type contact layer 13. Accordingly, the small coverage rapidly increases the power consumption in the light emitting diode 1.

In the light emitting diode 1 of the present comparative example, since the coverage is not less than 10 percent, the contact resistance between the anode electrode 17 and the p-type contact layer 13 can be made low, whereby it is feasible to prevent the decrease of the luminous efficiency and the increase of the power consumption due to heat generation.

In the light emitting diode 1 of the present comparative example, the pattern of the anode electrode 17 on the p-type contact layer 13 is uniform. The patterned anode electrode 17 enables the driving current to uniformly flow to the active layer 9 and can supply a sufficient amount of electric current to the active layer 9, thereby preventing the luminous efficiency from decreasing due to the patterned anode electrode 17.

In the light emitting diode 1 of the present comparative example, since the anode electrode 17 is shaped in a lattice pattern, it is feasible to supply the sufficient, uniform amount of electric current to the active layer 9 and to suppress the decrease of the luminous efficiency. In this case, each side of the unit lattice of the patterned anode electrode 17 is preferably not more than 60 micrometers. In other words, the distance from the edge of the anode electrode 17 to any point on the p-type contact layer 13 outside the anode electrode 17 is preferably not more than 30 micrometers.

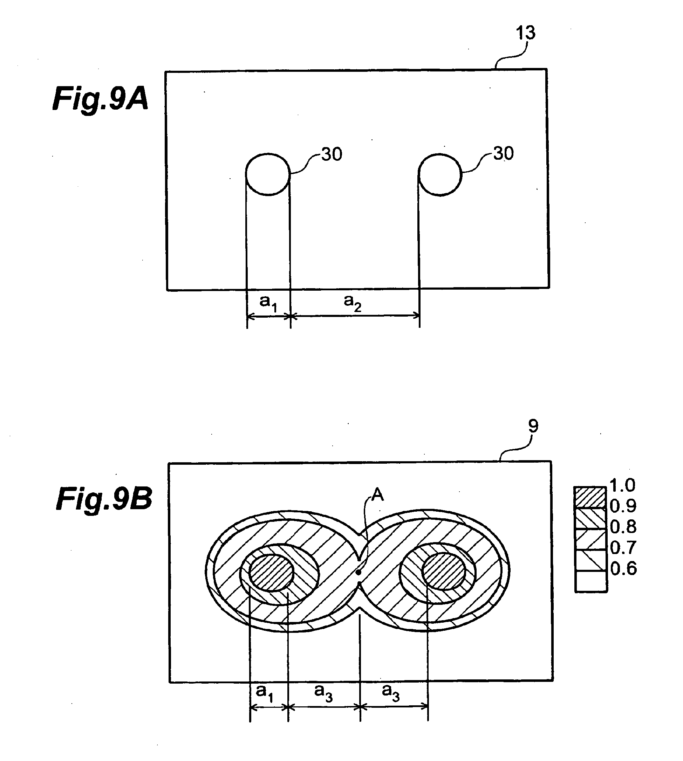

Fig. 9A and Fig. 9B are diagrams explaining the analysis result of current density in the active layer 9 depending on the distance measured from an electrode for anode. Fig. 9A shows the shape of unit electrodes 30 for anode in a light emitting diode for analysis. This analysis is carried out under the conditions that the diameter of the two unit electrodes 30 for anode (indicated by symbol a₁ in Fig. 9A) is 20 micrometers and the interval between these unit electrodes 30 (indicated by symbol a₂ in Fig. 9A) 60 micrometers.

Fig. 9B is a diagram showing the analysis result in the unit electrodes shown in Fig. 9A. Fig. 9B shows an electric current distribution in the active layer 9 where the amount of current density is normalized by the amount of current immediately below the unit electrodes 30, i.e., the normalized current density immediately below the anode electrodes is one. With reference to Fig. 9B, where the interval a₂ between the unit electrodes 30 is within 60 micrometers, the normalized current density is not less than 0.7 at the position equidistant, distance a₃, from both unit electrodes 30 (indicated by symbol A in the figure) and the sufficient current density is realized. Namely, the sufficient, uniform driving current can be made to flow to the active layer 9 as long as the distance between the adjacent unit anode electrodes 17 is not more than 60 micrometers, in other words, as long as the distance between the unit anode electrodes 17 and any point on the p-type contact layer 13 outside the anode electrode 17 is not more than 30 micrometers. In the light emitting diode 1 of the present comparative example, the sufficient, uniform driving current can be made to flow to the active layer 9, and it is thus feasible to suppress the decrease of the luminous efficiency due to the patterned anode electrode 17.

In the light emitting diode 1 of the present comparative example, the contact resistivity between the anode electrode 17 and the p-type contact layer 13 is not more than 1 × 10⁻³ Ωcm². This permits the light emitting diode to suppress the excess generation of heat in the contact between the anode electrode 17 and the p-type contact layer 13, and it is thus feasible to prevent the decrease of the luminous efficiency and the increase of power consumption due to the excess heat.

The light emitting diode 1 of the present comparative example has the adhesive layer 21 containing Ti in the following arrangements: between the p-type contact layer 13 and the reflecting metal layer 19; between the anode electrode 17 and the reflecting metal layer 19. This does not deteriorate the electrical connection between the anode electrode 17 and the reflecting metal layer 19 and can prevent the reflecting metal layer 19 from peeling off from the p-type contact layer 13 and from the anode electrode 17.

### (Second Comparative Example)

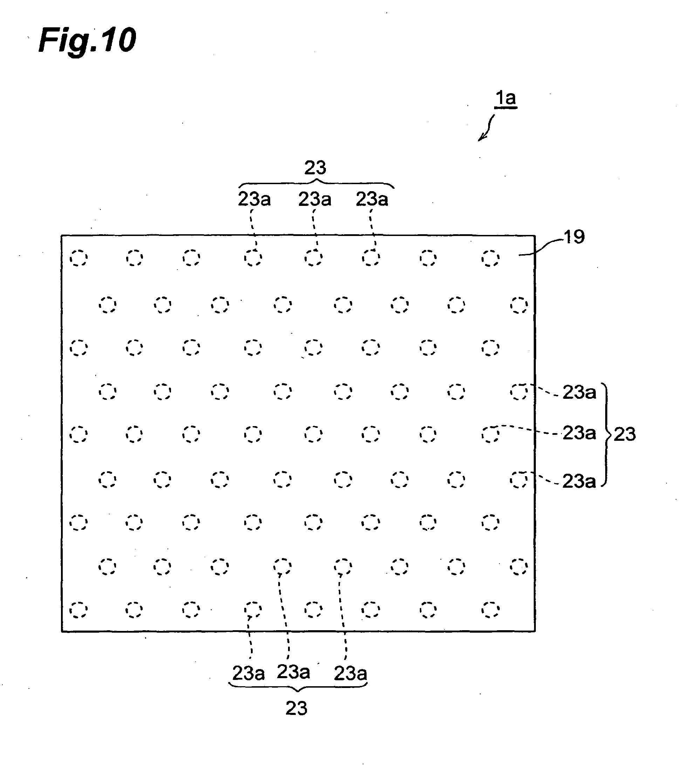

Fig. 10 is an view illustrating a light emitting diode 1a shown as the second comparative example of the semiconductor light emitting device. Fig. 10 is a top view of the light emitting diode 1a and shows the reflecting metal layer 19 and anode electrode 23. The light emitting diode 1a of the present comparative example is different in the pattern of the anode electrode from the light emitting diode 1 of the above-described first comparative example. The light emitting diode 1a has the same configuration as that of the light emitting diode 1 of the first comparative example except for the configuration of the anode electrode 23, and thus the description of the same items will be omitted.

With reference to Fig. 10, the light emitting diode 1a of the present comparative example has the patterned anode electrode 23 constituted by a plurality of units 23a separated from each other. The anode electrode 23 is provided on the p-type contact layer (not shown) and the material of the anode electrode 23 is the same as or similar to that of the anode electrode 17 of the first comparative example. The anode electrode 23 and the p-type contact layer form ohmic contact as in the first comparative example.

In the pattern of the anode electrode 23, four or six adjacent units 23a (six units in the present embodiment) are regularly arranged for each unit 23a. The diameter of each unit 23a is not more than 100 micrometers (the diameter is 20 micrometers in the present comparative example), and the interval between the nearest neighbor units 23a is not more than 60 micrometers (the interval is 50 micrometers in the present embodiment). Namely, in the present comparative example, the total coverage of the surface of the p-type contact layer with the units 23a in the light emitting diode 1a is 14 percent. In the present comparative example, the coverage of the surface of the p-type contact layer with the anode electrode 23 including the units 23a is preferably not less than 10 percent nor more than 60 percent just as in the first comparative example. The interval between the mutually adjacent units 23a is preferably not more than 60 micrometers, as described with reference to Fig. 9; in other words, the distance from each unit 23a to any point on the p-type contact layer outside the unit 23a is preferably not more than 30 micrometers.

In the light emitting diode 1a of the present comparative example, the units 23a are regularly arranged to form the pattern of the anode electrode 23. This enables the driving current to efficiently flow to the active layer, whereby it is feasible to suppress the reduction of the luminous efficiency due to the patterned structure of the anode electrode 23. The analysis conducted by the Inventors reveals that the light emitting diode 1a of the present comparative example has demonstrated the increase of about 38 percent in emission intensity at the driving current of 20 mA as compared with a conventional semiconductor light emitting device with the anode electrode over the entire surface of the p-type contact layer.

### (First Embodiment)

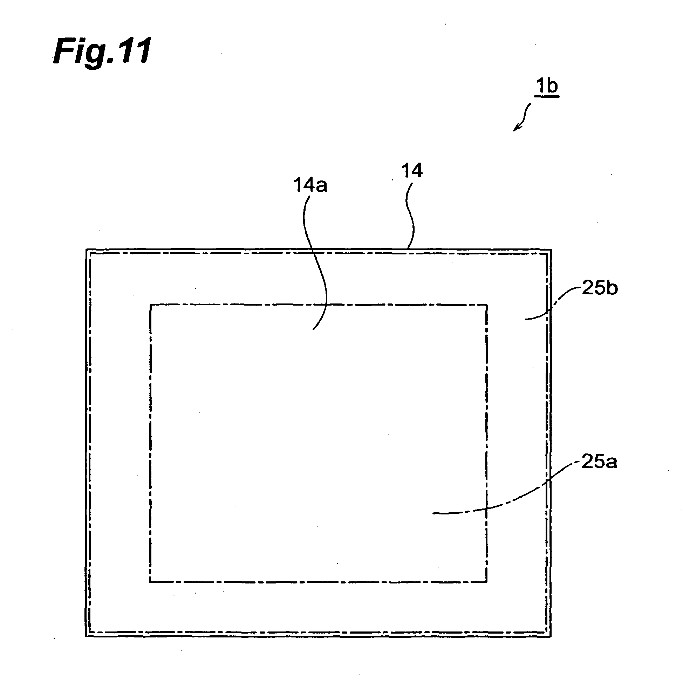

Subsequently, the first embodiment of the semiconductor light emitting device according to the present invention will be described. One example of semiconductor light emitting devices according to the present embodiment is a light emitting diode of the size 2 x 2 millimeters. Fig. 11 is a view of the front surface 14a of the p-type contact layer 14 in the light emitting diode 1b of the present embodiment. The p-type contact layer 14 in the present embodiment is similar to the p-type contact layer 13 in the first comparative example except for the following point: the surface 14a of the p-type contact layer 14 in the present embodiment has a first region 25a and a second region 25b. The first region 25a has a geometrically similar figure to the shape of the surface 14a (for example, rectangle in this embodiment) and is located in the middle of the surface 14a. The second region 25b surrounds the first region 25a in the surface 14a.

The anode electrode has a first portion formed in a first pattern on the first region 25a and the anode electrode also has a second portion formed in a second pattern on the second region 25b, and a ratio of the area of the first portion to that of the first region 25a is larger than a ratio of the area of the second portion to that of the second region 25b. In other words, the coverage of the first region 25a with the first portion of the anode electrode is larger than the coverage of the second region 25b with the second portion of the anode electrode on the p-type contact layer 14.

In the present embodiment, each of the first and second patterns of the anode electrode is constituted by a plurality of units (not shown). In the first pattern of the anode electrode, the diameter of each unit is, for example, 20 micrometers and the interval between the mutually adjacent units, for example, 50 micrometers. In the second pattern, the diameter of each unit is, for example, 15 micrometers and the interval between the mutually adjacent units, for example, 60 micrometers. In this configuration, the coverage by use of the first pattern is 14 percent, and the coverage by use of the second pattern is 5.5 percent. Then the total coverage by use of the first and second patterns is 10 percent.

In general, light generated by the active layer tends to be concentrated in the marginal region of the light emitting diode 1b. In the present embodiment, since the area of the reflecting metal layer in the marginal region of the light emitting diode 1b is large (i.e., in the second region 25b), the optical output efficiency of light generated by the active layer can be further increased. The analysis conducted by the Inventors reveals that the light emitting diode 1b of the present embodiment has demonstrated the increase of about 38 percent in emission intensity at the driving current of 200 mA as compared with the conventional semiconductor light emitting device that has the anode electrode over the entire surface of the p-type contact layer.

### (Fourth Embodiment)

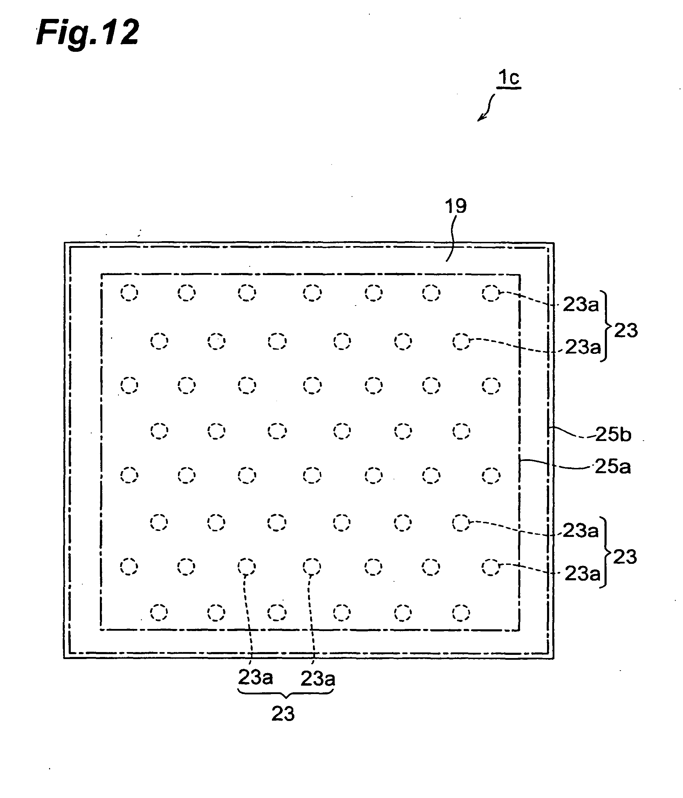

Fig. 12 is a view illustrating a light emitting diode 1c shown as the second comparative example of the semiconductor light emitting device. Fig. 12 is a view of the light emitting diode 1c, and shows the reflecting metal layer 19 and a plurality of units 23a forming the pattern of the anode electrode 23. The light emitting diode 1c of the present comparative example is different in the pattern shape of the anode electrode 23 from the light emitting diode 1 of the first comparative example. In the present comparative example, the anode electrode 23 is provided only in the first region 25a of the surface of the p-type contact layer but is not provided in the second region 25b. The diameter of each unit 23a and the interval between the units 23a are similar to those in the second embodiment.

The light emitting diode 1c of the present comparative example can also achieve advantages similar to that in each of the above comparative example and embodiment. The analysis conducted by the Inventors reveals that the light emitting diode 1c of the present comparative example has demonstrated the increase of about 56 percent in emission intensity at the driving current of 20 mA as compared with the conventional semiconductor light emitting device that has the anode electrode over the entire surface of the p-type contact layer.

### (Second Embodiment)

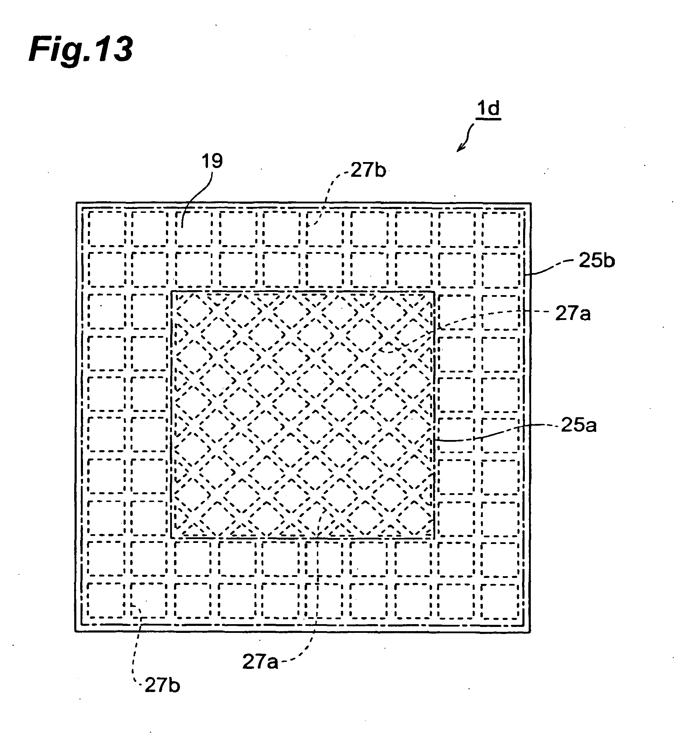

Fig. 13 is a view illustrating a light emitting diode 1d shown as the second embodiment of the semiconductor light emitting device according to the present invention. Fig. 13 is a view of the light emitting diode 1d and shows the reflecting metal layer 19 and first and second parts 27a and 27b of the anode electrode. The light emitting diode 1d of the present embodiment is different in the pattern of the anode electrode from the light emitting diode 1 of the first comparative example. In the present embodiment, the first part 27a of the anode electrode is provided in the first region 25a in the surface of the p-type contact layer and the second part 27b of the anode electrode is provided in the second region 25b.

The first part 27a of the anode electrode has a pattern to form a lattice and the second part 27b of the anode electrode has another pattern to form another lattice. The size of each unit of the second part 27b of the anode electrode is the same as or similar to that in the first comparative example. The size of the unit of the first part 27a of the anode electrode is smaller than that of the second part 27b. In this embodiment, the pattern for the first part 27a in the first region 25a is denser than the pattern for the second part 27b in the second region 25b.

The light emitting diode 1d of the present embodiment also has advantages similar to those in each of the above comparative examples and embodiment.

The semiconductor light emitting devices according to the present invention are not limited to the above-described embodiments, and a variety of modifications can be further made. For example, a variety of patterns in addition to those in the above embodiments are used as patterns for the anode electrode (a lattice or a plurality of units). The semiconductor light emitting devices in the above embodiments have the substrate of GaN, but the substrate of this type is not essential. For example, a modified semiconductor light emitting device may also be formed by sequentially growing the n-type semiconductor film, active region, and p-type semiconductor film of GaN-based semiconductors on a sapphire substrate and separating these films from the sapphire substrate. The present invention is also applicable to the semiconductor light emitting device of this type.

Having described and illustrated the principle of the invention in a preferred embodiment thereof, it is appreciated by those having skill in the art that the invention can be modified in arrangement and detail without departing from such principles. The present invention shall not be limited to the specific examples disclosed in the specification. We therefore claim all modifications and variations coming within the scope of the following claims.

## Claims

1. A semiconductor light emitting device comprising:
a first conductivity type semiconductor layer (5, 6, 7) made of nitride semiconductor;
a second conductivity type semiconductor layer (11, 12, 13, 14) made of nitride semiconductor, the second conductivity type semiconductor layer being provided on the first conductivity type semiconductor layer;
an active layer (9) made of nitride semiconductor, the active layer being provided between the first conductivity type semiconductor layer and the second conductivity type semiconductor layer;
a first electrode (15) electrically connected to the first conductivity type semiconductor layer;
a second electrode (17, 23) provided on the second conductivity type semiconductor layer, the second electrode having a predetermined pattern; and
a reflecting metal layer (19) provided on the second conductivity type semiconductor layer and the second electrode;
wherein a surface (14a) of the second conductivity type semiconductor layer has a first region (25a) and a second region (25b) surrounding the first region,
wherein the patterned second electrode includes a first portion having a first pattern on the first region and a second portion having a second pattern on the second region, and
wherein a ratio of a planar dimension of the first portion of the patterned second electrode to that of the first region is larger than a ratio of a planar dimension of the second portion of the patterned second electrode to that of the second region.

2. The semiconductor light emitting device according to claim 1, wherein the first conductivity type semiconductor layer is made of Alₓ₁Ga₁₋ₓ₁N (0 ≤ X1 < 1) and the second conductivity type semiconductor layer is made of Alₓ₂Gal₁₋ₓ₂N (0 ≤ X2 < 1), and wherein the active layer is made of Alₓ₃In_{Y3}Ga_{1-X3-Y3}N (0 ≤ X3 <1, 0 ≤ Y3 < 1, 0 ≤ X3 + Y3 < 1).

3. The semiconductor light emitting device according to claim 1 or 2, further comprising a substrate made of a GaN-based compound, the first conductivity type semiconductor layer being provided on a primary surface of the substrate, and the first electrode being provided on a back surface of the substrate.

4. The semiconductor light emitting device according to claim 3, wherein a specific resistance of the substrate is not more than 0.5 Ωcm.

5. The semiconductor light emitting device according to any one of claims 1 to 4, wherein reflectance of the reflecting metal layer is not less than 80 percent in a wavelength range of not less than 400 nanometers nor more than 800 nanometers.

6. The semiconductor light emitting device according to any one of claims 1 to 5, wherein the reflecting metal layer is made of metal containing at least one of silver (Ag) and aluminum (Al).

7. The semiconductor light emitting device according to any one of claims 1 to 6, wherein a surface of the second conductivity type semiconductor layer has a first portion and a second portion, the first portion is covered with the second electrode, the second portion is not covered with the second electrode, and an area ratio of the first portion to sum of the first and second portions is not more than 60 percent.

8. The semiconductor light emitting device according to any one of claims 1 to 7, wherein the first and/or second pattern is/are of a lattice shape.

9. The semiconductor light emitting device according to claim 8, wherein the lattice shape of the pattern is constituted by a unit lattice (23a) and a side of the unit lattice is not more than 60 micrometers.

10. The semiconductor light emitting device according to any one of claims 1 to 7,
wherein the first and/of second pattern is/are constituted by a plurality of units separated from each other.

11. The semiconductor light emitting device according to claim 10, wherein the plurality of units are regularly arranged to form the pattern and each unit in the pattern has four or six nearest neighbor units.

12. The semiconductor light emitting device according to claim 10 or 11, wherein an interval between the units adjacent to each other is not more than 60 micrometers.

13. The semiconductor light emitting device according to any one of claims 1 to 12, wherein an interval between the edge of the second electrode and any point on the second conductivity type semiconductor layer outside the second electrode is not more than 30 micrometers.

14. The semiconductor light emitting device according to any one of claims 1 to 13, wherein a contact resistivity between the second electrode and the second conductivity type semiconductor layer is not more than 1 x 10⁻³ Ω cm².

15. The semiconductor light emitting device according to any one of claims 1 to 14, wherein the second electrode is made of at least one metal of Ni, Au, Pt and Pd.

16. The semiconductor light emitting device according to any one of claims 1 to 15, further comprising a contact layer provided on the second conductivity type semiconductor layer, the contact layer contacting with the second electrode.

17. The semiconductor light emitting device according to any one of claims 1 to 16, wherein a planar dimension of the second electrode is not less than 10 percent of that of the second conductivity type semiconductor layer.

18. The semiconductor light emitting device according to any one of claims 1 to 17, further comprising an adhesive layer (21) containing titanium (Ti), the adhesive layer being provided between the reflecting metal layer and the second conductivity type semiconductor layer and between the reflecting metal layer and the second electrode.

## Patentansprüche

1. Licht emittierende Halbleitereinrichtung umfassend:
eine Halbleiterschicht mit einer ersten Leitfähigkeit (5, 6, 7) aus einem Nitridhalbleiter;
eine Halbleiterschicht mit einer zweiten Leitfähigkeit (11, 12, 13, 14) aus einem Nitridhalbleiter, wobei die Halbleiterschicht mit der zweiten Leitfähigkeit auf der Halbleiterschicht mit der ersten Leitfähigkeit ausgebildet ist;
eine aktive Schicht (9) aus einem Nitridhalbleiter, wobei die aktive Schicht zwischen der Halbleiterschicht mit der ersten Leitfähigkeit und der Halbleiterschicht mit der zweiten Leitfähigkeit ausgebildet ist;
eine erste Elektrode (15), die mit der Halbleiterschicht mit der ersten Leitfähigkeit elektrisch verbunden ist;
eine zweite Elektrode (17, 23), die auf der Halbleiterschicht mit der zweiten Leitfähigkeit ausgebildet ist, wobei die zweite Elektrode ein vorbestimmtes Muster aufweist; und
eine reflektierende Metallschicht (19), die auf der Halbleiterschicht mit der zweiten Leitfähigkeit und der zweite Elektrode ausgebildet ist;
wobei eine Oberfläche (14a) der Halbleiterschicht mit der zweiten Leitfähigkeit einen ersten Bereich (25a) und einen zweiten, den ersten Bereich umgebenden Bereich (25b) aufweist,
wobei die strukturierte zweite Elektrode einen ersten Teil mit einem ersten Muster auf dem ersten Bereich und einen zweiten Teil mit einem zweiten Muster auf dem zweiten Bereich umfasst, und
wobei ein Verhältnis einer Ebenenabmessung des ersten Teils der strukturierten zweiten Elektrode zu der des ersten Bereichs größer ist als ein Verhältnis einer Ebenenabmessung des zweiten Teils der strukturierten zweiten Elektrode zu der des zweiten Bereichs.

2. Licht emittierende Halbleitereinrichtung gemäß Anspruch 1, wobei die Halbleiterschicht mit der ersten Leitfähigkeit aus Al_{X1}Ga_{1-X1}N (0 ≤ X1 < 1) und die Halbleiterschicht mit der zweiten
Leitfähigkeit aus Al_{X2}Ga_{1-X2}N (0 ≤ X2 < 1) gebildet ist, und wobei die aktive Schicht aus Al_{X3}In_{Y3}Ga_{1-X3-Y3}N (0 ≤ X3 < 1, 0 ≤ Y3 < 1, 0 ≤ X3 + Y3 < 1) gebildet ist.

3. Licht emittierende Halbleitereinrichtung gemäß Anspruch 1 oder 2, die des Weiteren ein Substrat aus einer Verbindung auf GaN-Basis umfasst, wobei die Halbleiterschicht mit der ersten Leitfähigkeit auf einer Hauptfläche des Substrats und die erste Elektrode auf der Rückseitenfläche des Substrats ausgebildet ist.

4. Licht emittierende Halbleitereinrichtung gemäß Anspruch 3, wobei ein spezifischer Widerstand des Substrats nicht mehr als 0,5 Ωcm beträgt.

5. Licht emittierende Halbleitereinrichtung gemäß einem der Ansprüche 1 bis 4, wobei ein Reflexionsvermögen der reflektierenden Metallschicht nicht weniger als 80% in einem Wellenlängenbereich von nicht weniger als 400 Nanometer und nicht mehr als 800 Nanometer beträgt.

6. Licht emittierende Halbleitereinrichtung gemäß einem der Ansprüche 1 bis 5, wobei die reflektierende Metallschicht aus zumindest einem der Metalle umfassend Silber (Ag) und Aluminium (Al) gebildet ist.

7. Licht emittierende Halbleitereinrichtung gemäß einem der Ansprüche 1 bis 6, wobei eine Oberfläche der Halbleiterschicht mit der zweiten Leitfähigkeit einen ersten Teil und einen zweiten Teil aufweist, wobei der erste Teil von der zweiten Elektrode bedeckt ist, der zweite Teil nicht von der zweiten Elektrode bedeckt ist und ein Flächenverhältnis des ersten Teils zur Summe des ersten und zweiten Teils nicht mehr als 60% beträgt.

8. Licht emittierende Halbleitereinrichtung gemäß einem der Ansprüche 1 bis 7, wobei das erste und/oder zweite Muster eine Gitterform aufweist/aufweisen.

9. Licht emittierende Halbleitereinrichtung gemäß Anspruch 8, wobei die Gitterform des Musters aus einem Einheitsgitter (23a) gebildet und eine Seite des Einheitsgitters nicht länger als 60 Mikrometer ist.

10. Licht emittierende Halbleitereinrichtung gemäß einem der Ansprüche 1 bis 7, wobei das erste und/oder zweite Muster aus mehreren voneinander getrennten Einheiten gebildet ist/sind.

11. Licht emittierende Halbleitereinrichtung gemäß Anspruch 10, wobei die mehreren Einheiten gleichmäßig angeordnet sind, um das Muster zu bilden, und jede Einheit in dem Muster weist vier oder sechs nächstliegende Nachbareinheiten auf.

12. Licht emittierende Halbleitereinrichtung gemäß Anspruch 10 oder 11, wobei ein Abstand zwischen benachbart zueinander liegenden Einheiten nicht mehr als 60 Mikrometer beträgt.

13. Licht emittierende Halbleitereinrichtung gemäß einem der Ansprüche 1 bis 12, wobei ein Abstand zwischen dem Rand der zweiten Elektrode und irgendeinem Punkt auf der Halbleiterschicht mit der zweiten Leitfähigkeit außerhalb der zweiten Elektrode nicht mehr als 30 Mikrometer beträgt.

14. Licht emittierende Halbleitereinrichtung gemäß einem der Ansprüche 1 bis 13, wobei ein Kontaktwiderstand zwischen der zweiten Elektrode und der Halbleiterschicht mit der zweiten Leitfähigkeit nicht mehr als 1x10⁻³ Ωcm² beträgt.

15. Licht emittierende Halbleitereinrichtung gemäß einem der Ansprüche 1 bis 14, wobei die zweite Elektrode aus zumindest einem der Metalle umfassend Ni, Au, Pt und Pd gebildet ist.

16. Licht emittierende Halbleitereinrichtung gemäß einem der Ansprüche 1 bis 15, die des Weiteren eine Kontaktschicht umfasst, die auf der Halbleiterschicht mit der zweiten Leitfähigkeit vorgesehen ist, wobei die Kontaktschicht mit der zweiten Elektrode in Kontakt ist.

17. Licht emittierende Halbleitereinrichtung gemäß einem der Ansprüche 1 bis 16, wobei eine Ebenenabmessung der zweiten Elektrode nicht weniger als 10% von jener der Halbleiterschicht mit der zweiten Leitfähigkeit beträgt.

18. Licht emittierende Halbleitereinrichtung gemäß einem der Ansprüche 1 bis 17, die des Weiteren eine Klebeschicht (21) umfassend Titan (Ti) aufweist, wobei die Klebeschicht zwischen der reflektierenden Metallschicht und der Halbleiterschicht mit der zweiten Leitfähigkeit und zwischen der reflektierenden Metallschicht und der zweiten Elektrode vorgesehen ist.

## Revendications

1. Dispositif semi-conducteur émettant de la lumière, comprenant :
une couche semi-conductrice d'un premier type de conductivité (5, 6, 7) constituée d'un semi-conducteur au nitrure ;
une couche semi-conductrice d'un deuxième type de conductivité (11, 12, 13, 14) constituée d'un semi-conducteur au nitrure, la couche semi-conductrice d'un deuxième type de conductivité étant pourvue sur la couche semi-conductrice d'un premier type de conductivité ;
une couche active (9) constituée d'un semi-conducteur au nitrure, la couche active étant pourvue entre la couche semi-conductrice d'un premier type de conductivité et la couche semi-conductrice d'un deuxième type de conductivité ;
une première électrode (15) connectée électriquement à la couche semi-conductrice d'un premier type de conductivité ;
une deuxième électrode (17, 23) pourvue sur la couche semi-conductrice d'un deuxième type de conductivité, la deuxième électrode présentant un motif prédéterminé ; et
une couche métallique réfléchissante (19) pourvue sur la couche semi-conductrice d'un deuxième type de conductivité et sur la deuxième électrode ;
dans lequel une surface (14a) de la couche semi-conductrice d'un deuxième type de conductivité comporte une première région (25a) et une deuxième région (25b) entourant la première région,
dans lequel la deuxième électrode à motif comprend une première partie ayant un premier motif sur la première région et une deuxième partie ayant un deuxième motif sur la deuxième région, et
dans lequel un ratio d'une dimension plane de la première partie de la deuxième électrode à motif par rapport à celle de la première région est supérieur au ratio d'une dimension plane de la deuxième partie de la deuxième électrode à motif par rapport à celle de la deuxième région.

2. Dispositif semi-conducteur émettant de la lumière selon la revendication 1, dans lequel la couche semi-conductrice d'un premier type de conductivité est constituée d'Al_{X1}Ga_{1-X}N (0 ≤ X1 < 1) et la
couche semi-conductrice d'un deuxième type de conductivité est constituée d'Al_{X2}Ga_{1-X2}N (0 ≤ X2 < 1), et dans lequel la couche active est constituée d'Al_{X3}In_{Y3}Ga_{1-X3-Y3}N (0 ≤ X3 <1, 0 ≤ Y3 < 1, 0 ≤ X3 + Y3 < 1).

3. Dispositif semi-conducteur émettant de la lumière selon la revendication 1 ou 2, comprenant en outre un substrat constitué d'un composé à base de GaN, la couche semi-conductrice d'un premier type de conductivité étant pourvue sur une surface principale du substrat, et la première électrode étant pourvue sur une surface arrière du substrat.

4. Dispositif semi-conducteur émettant de la lumière selon la revendication 3, dans lequel une résistivité du substrat est inférieure ou égale à 0,5 Ω·cm.

5. Dispositif semi-conducteur émettant de la lumière selon l'une quelconque des revendications 1 à 4, dans lequel la réflectivité de la couche métallique réfléchissante est supérieure ou égale à 80 pourcent dans une plage de longueur d'onde supérieure ou égale à 400 nanomètres et inférieure ou égale à 800 nanomètres.

6. Dispositif semi-conducteur émettant de la lumière selon l'une quelconque des revendications 1 à 5, dans lequel la couche métallique réfléchissante est constituée d'un métal contenant au moins un des métaux parmi l'argent (Ag) et l'aluminium (A1).

7. Dispositif semi-conducteur émettant de la lumière selon l'une quelconque des revendications 1 à 6, dans lequel une surface de la couche semi-conductrice d'un deuxième type de conductivité comporte une première partie et une deuxième partie, la première partie est recouverte par la deuxième électrode, la deuxième partie n'est pas recouverte par la deuxième électrode, et un ratio de surface de la première partie par rapport à la somme des première et deuxième parties est inférieur ou égal à 60 pourcent.

8. Dispositif semi-conducteur émettant de la lumière selon l'une quelconque des revendications 1 à 7, dans lequel le premier et/ou le deuxième motif présente(nt) une forme de treillis.

9. Dispositif semi-conducteur émettant de la lumière selon la revendication 8, dans lequel la forme de treillis du motif est constituée par un treillis unitaire (23a) et un côté du treillis unitaire est inférieur ou égal à 60 micromètres.

10. Dispositif semi-conducteur émettant de la lumière selon l'une quelconque des revendications 1 à 7, dans lequel les premier et/ou deuxième motifs est/sont constitués d'une pluralité d'unités séparées entre elles.

11. Dispositif semi-conducteur émettant de la lumière selon la revendication 10, dans lequel la pluralité d'unités sont agencées régulièrement pour former le motif et chaque unité du motif a quatre ou six unités voisines les plus proches.

12. Dispositif semi-conducteur émettant de la lumière selon la revendication 10 ou 11, dans lequel un intervalle entre les unités adjacentes est inférieur ou égal à 60 micromètres.

13. Dispositif semi-conducteur émettant de la lumière selon l'une quelconque des revendications 1 à 12, dans lequel un intervalle entre le bord de la deuxième électrode et un point quelconque sur la couche semi-conductrice d'un deuxième type de conductivité en dehors de la deuxième électrode est inférieur ou égal à 30 micromètres.

14. Dispositif semi-conducteur émettant de la lumière selon l'une quelconque des revendications 1 à 13, dans lequel une résistivité de contact entre la deuxième électrode et la couche semi-conductrice d'un deuxième type de conductivité est inférieure ou égale à 1 x 10⁻³ Ω.cm².

15. Dispositif semi-conducteur émettant de la lumière selon l'une quelconque des revendications 1 à 14, dans lequel la deuxième électrode est constituée d'au moins un métal parmi Ni, Au, Pt et Pd.

16. Dispositif semi-conducteur émettant de la lumière selon l'une quelconque des revendications 1 à 15, comprenant en outre une couche de contact pourvue sur la couche semi-conductrice d'un deuxième type de conductivité, la couche de contact étant en contact avec la deuxième électrode.

17. Dispositif semi-conducteur émettant de la lumière selon l'une quelconque des revendications 1 à 16, dans lequel une dimension plane de la deuxième électrode est supérieure ou égale à 10 pourcent de celle de la couche semi-conductrice d'un deuxième type de conductivité.

18. Dispositif semi-conducteur émettant de la lumière selon l'une quelconque des revendications 1 à 17, comprenant en outre une couche adhésive (21) contenant du titane (Ti), la couche adhésive étant pourvue entre la couche métallique réfléchissante et la couche semi-conductrice d'un deuxième type de conductivité et entre la couche métallique réfléchissante et la deuxième électrode.
